# EUROPEAN PATENT APPLICATION

(11) **EP 0 600 437 A2**
(43) Date of publication of application: **08.06.1994**
(21) Application number: 93119272.8
(22) Date of filing: 30.11.1993
(51) Int. Cl.: H01L 29/60, H01L 29/784, H01L 27/11

(54) **Gate defined transistor**

(30) Priority: 30.11.1992 US 985094
(71) Applicant: TEXAS INSTRUMENTS INCORPORATED, Dallas Texas 75265 (US)
(72) Inventor: Mahant-Shetti, Shivaling, Richardson, TX 75082 (US)
(74) Representative: Schwepfinger, Karl-Heinz, Dipl.-Ing.

(57) **Abstract**

A transistor (40) comprises a gate conductor (42) that includes a notch (62). The transistor (40) comprises a channel region (50) which has both a length and width dimension defined by the photolithographic patterning of gate conductor (42). The formation of bird's beak structures (76) and (78) associated with field oxide layer (72) and (74) will not affect the current carrying capability of the transistor (42).

## Description

### TECHNICAL FIELD OF THE INVENTION

This invention relates in general to the field of semiconductor devices and more particularly to an improved gate defined transistor and method for forming same.

### BACKGROUND OF THE INVENTION

An important goal in designing field effect transistors for integrated circuit applications is the ability to create a transistor that can conduct a sufficient amount of current when turned on and yet will conduct little or no current when turned off A further consideration is the ability to accurately control the size and current capacity of the transistor and to eliminate the effect of process variations that can cause variability in these parameters. These concerns are acute in designing access transistors for static random access memory cells. Due to the configuration of the standard static random access memory cell, the cell size is usually defined by the size of the access transistor. Designers require the access transistor to be very small in order to reduce the cell size. However, the access transistor must be very carefully constructed so that the current capacity of the transistor is well defined.

The channel length of a field effect transistor is ordinarily defined by the width of the gate disposed over the channel. The channel width is defined by the width of the diffusions of the source and drain areas and by the degree to which the field oxide surrounding the transistor and isolating the transistor from other devices impinges on the channel. The mode in which the field oxide impinges into the channel area is commonly referred to as a bird's beak. The length of the field oxide bird's beak is difficult to control and thus the channel size of field effect transistors can vary undesirably.

Accordingly, a need has arisen for a structure for and a method for forming a field effect transistor that reduces the effect of bird's beak problems on the sizing and construction of the transistor.

### SUMMARY OF THE INVENTION

In accordance with the teachings of the present invention, a gate-defined transistor is provided which substantially eliminates or reduces disadvantages associated with prior transistor layouts.

According to one embodiment of the present invention, a transistor is provided that comprises a transistor formed proximate a surface of a semiconductor substrate comprising a source region proximate the surface, a drain region proximate the surface and spaced apart from the source region defining a channel region of the substrate between the source and drain regions, and a gate conductor disposed proximate the channel region and insulated from the channel region. The gate conductor is operable to electrically control the conductance of the channel region and comprises a notch proximate the channel region such that the length and width of the active portion are substantially determined by the size of the gate conductor and the notch.

An important technical advantage of the present invention inheres in the fact that the structure of the gate of the transistor of the present invention provides that the size of the channel is determined largely by the pattern of the gate conductor material and not by the degree in which the bird's beak structures of the field oxide impinges on the channel area. A further technical advantage of the present invention inheres in the fact that the advantages of the channel sizing using the gate conductor material are provided at little cost in parasitic capacitance or cell size.

### BRIEF DESCRIPTION OF THE DRAWINGS

A more complete understanding of the present invention may be acquired by referring to the accompanying figures in which like reference numbers indicate like features and wherein:
FIGUREs 1a - 1c represent schematic views of a conventional field effect transistor;
FIGUREs 2a - 2c are schematic views of a field effect transistor constructed according to the teachings of the present invention; and
FIGURE 3 is a schematic illustration of a layout of several transistors constructed according to the teachings of the present invention.

### DETAILED DESCRIPTION OF THE INVENTION

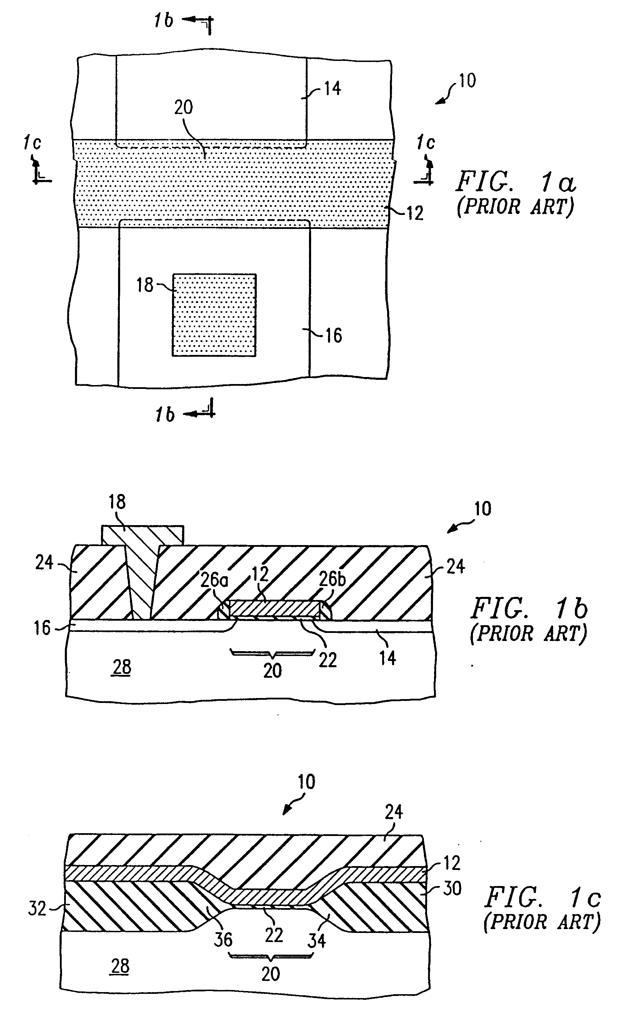

FIGUREs 1a - 1c are schematic illustrations of field effect transistors constructed according to conventional methods which will be used herein to illustrate the problems addressed by the teachings of the present invention. Referring to FIGURE 1a, a field effect transistor indicated generally at 10 is illustrated in a top view. Field effect transistor 10 comprises a gate conductor 12 which may comprise polycrystalline silicon which has been doped with sufficient impurities so as to render it conductive. If transistor 10 is used as an access transistor to a conventional SRAM cell, gate conductor 12 is a portion of a word line connecting a plurality of memory cells. Transistor 10 further comprises a source region 14 and a drain region 16. Source and drain regions 14 and 16 comprise diffused areas of a semiconductor substrate. The terms source and drain are used as a convenience to aid in describing the advantages of the present invention. As with many field effect devices, transistor 10 is essentially a symmetric device having substantially interchangeable source and drain regions. FIGURE 1a also illustrates a bit line contact 18 which is used to connect a bit line to drain region 16. Transistor 10 further comprises a channel region 20 disposed beneath gate conductor 12 between source region 14 and drain region 16. The length of channel region 20 is determined by the distance between the edge of source region 14 and the edge of drain region 16. The width of channel region is determined by the amount of gate conductor 12 that is disposed in close proximity to the semiconductor substrate. This is determined by the placement of the field oxide structures which are not shown in FIGURE 1a but will be discussed with reference to FIGURE 1c.

FIGURE 1b is a cross-sectional illustration of transistor 10 taken along a plane perpendicular to the major axis of gate conductor 12 as shown in FIGURE 1a. FIGURE 1b illustrates the proximity of gate conductor 12 to channel region 20. Gate conductor 12 is separated from channel region 20 by a gate insulator layer 22 which is on the order of 100 angstroms in depth. Bit contact 18 is separated from the remaining structures by an isolation insulator layer 24 shown in FIGURE 1b. FIGURE 1b also illustrates spacer bodies 26a and 26b positioned on opposing sides of gate conductor 12. Spacer bodies 26a and 26b are commonly used to better control the formation of source region 14 and drain region 16. FIGURE 1b illustrates that the length of channel region 20 is determined by the distance between source region 14 and drain region 16. Transistor 10 is formed on a single crystalline semiconductor substrate 28 shown in FIGURE 1b.

FIGURE 1c is a cross-sectional illustration taken along a plane shown in FIGURE 1a parallel to the major axis of gate conductor 12. FIGURE 1c illustrates the problems addressed by the teachings of the present invention. On either side of channel region 20, field oxide bodies 30 and 32 are formed to isolate transistor 10 from proximate devices. According to the conventional operation of field effect devices, the majority of current conducted by transistor 10 will be in the portion of channel region 20 where gate conductor 12 is on the order of 100 angstroms from the outer surface of substrate 28. Less and less current will be conducted in the regions proximate the field oxide bodies 30 and 32 as gate conductor 12 will exert less and less influence over the conductive properties of substrate 28 the further gate conductor 12 is from the substrate 28. As such, the width of channel 20 is largely determined by the degree to which the field oxide bodies 30 and 32 impinge into region 20. For example, field oxide body 30 impinges into region 20 through the formation of bird's beak structure 34 shown in FIGURE 1c. Similarly, field oxide body 32 impinges into region 20 through the formation of bird's beak structure 36. The problem addressed by the teachings of the present invention is that the growth of bird's beak structures 34 and 36 is not easily controlled. For example, if region 20 is on the order of 1.5 microns in width, bird's beak structures 34 and 36 can effectively reduce this length by .5 microns ±.3 microns. The wide variance in the growth of bird's beak structures 34 and 36 means that a channel width which is laid out to be 1.5 microns in width can actually vary anywhere from .7 microns to 1.3 microns in width. This wide variance in channel width results in a wide variance in the conductive capability of transistor 10 and can lead to unpredictability in the operation of integrated circuits using transistor 10.

Conventional methods of combatting the wide variability in the growth of bird's beak structures merely involve increasing the size of the channel region to reduce the percentage of variance the growth of the bird's beak structures represent. This approach does not eliminate the problems associated with the bird's beak structures and further suffers from the drawback that the transistor size is increased. As discussed previously, in modern SRAM configurations, the size of the access transistor largely determines the cell size of the SRAM cell. Accordingly, an increase in the size of the access transistor can dramatically increase the size of the SRAM cell and consequently the size of the SRAM array.

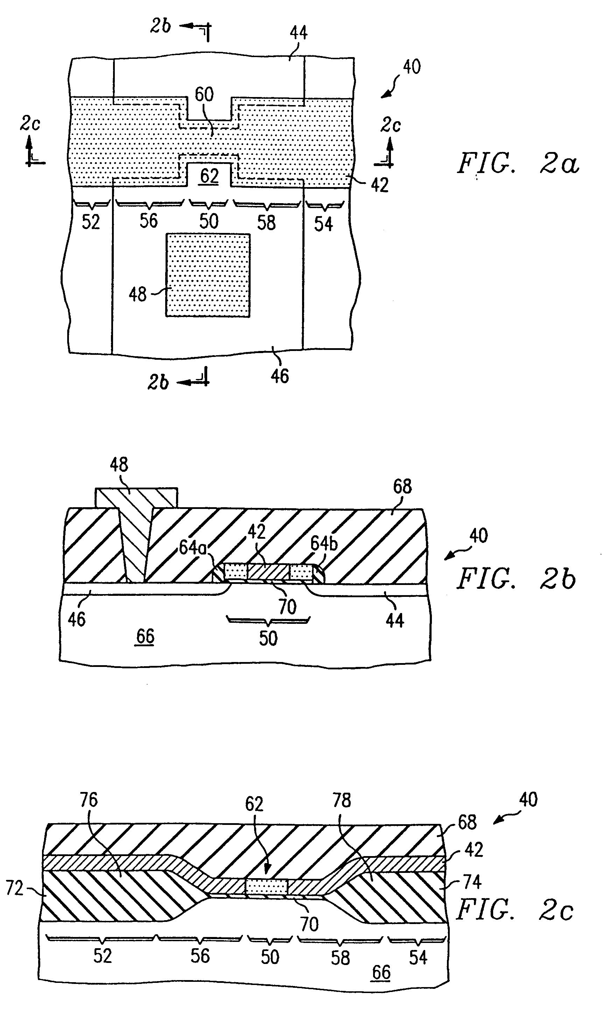

FIGURE 2a is a top view of a transistor 40 constructed according to the teachings of the present invention. Transistor 40 comprises a gate conductor 42 which may comprise, for example, polysilicon crystalline which is doped with sufficient impurities so as to render it conductive. Transistor 40 also comprises a source region 44 and a drain region 46 which may comprise diffused regions of a semiconductor substrate disposed on opposite sides of gate conductor 42. Contact is made to drain region 46 through a bit line contact 48. As discussed previously, if transistor 40 is used as an access transistor to a conventional SRAM cell, gate conductor 42 comprises a portion of a word line and bit line contact 48 serves to electrically couple drain region 46 to a bit line coupling a plurality of SRAM cells. For purposes of describing the technical advantages of the present invention, the length of gate conductor 42 will be divided into regions which will be described separately. The center portion of gate conductor 42 is disposed over a channel region 50 shown in FIGURE 2a. The outer portions of gate conductor 42 are disposed outwardly from field oxide regions 52 and 54 shown in FIGURE 2a. The remaining portions of gate conductor 42 shown in FIGURE 2a are disposed outwardly from bird's beak regions 56 and 58 shown in FIGURE 2a. The great majority of the current conducted through transistor 40 will be conducted in the portion of the substrate disposed proximate gate conductor 42 within region 50 shown in FIGURE 2a. A negligible amount of current will be conducted in the portions of the semiconductor substrate disposed beneath bird's beak regions 56 and 58. As shown in FIGURE 2a, gate conductor 42 is photolithographically formed to comprise notches 60 and 62. By including notches 60 and 62 in the structure of gate conductor 42, the influence of the impingement of bird's beak structures on the channel region is greatly reduced. The effective channel resides within region 50 and therefore the width of the channel of transistor 40 is determined by the width of notches 60 and 62 rather than by the degree in which bird's beak structures impinge within regions 56 and 58.

FIGURE 2b is a cross-sectional illustration taken along a section illustrated in FIGURE 2a perpendicular to the major axis of gate conductor 42. FIGURE 2b illustrates that the length of channel region 50 of transistor 40 is still determined by the distance between the source region 44 and the drain region 46. FIGURE 2b also illustrates that conventional spacer bodies 64a and 64b may be used to control the formation of drain region 46 and source region 44, respectively. FIGURE 2b also illustrates that transistor 40 is formed on the outer surface of a semiconductor substrate 66. Transistor 40 is covered with an isolation insulator layer 68. Gate conductor 42 is separated from channel region 50 by a gate insulator layer 70 which is on the order of 100 angstroms in depth and may comprise, for example, oxide. The separation between source region 44 and drain region 56 may be of a minimum geometry on the order of 1 to 1.5 microns in length.

FIGURE 2c is a cross-sectional illustration taken along a section shown in FIGURE 2a which is parallel to the major axis of gate conductor 42. FIGURE 2c has also been subdivided to show regions 50, 52, 54, 56 and 58 described with reference to FIGURE 2a. FIGURE 2c has also been taken along a section which illustrates the placement of notch 62. As shown in FIGURE 2c, field oxide layer 72 is disposed within field oxide region 52. Field oxide layer 74 is disposed within field oxide region 54. A bird's beak structure 76 extends from field oxide layer 72 into bird's beak region 56. Similarly, a bird's beak structure 78 extends from field oxide layer 74 into bird's beak region 58. Gate oxide layer 70 covers the entirety of channel region 50 and extends into bird's beak regions 56 and 58 on opposing sides of channel region 50. As described previously, the majority of the current passing through transistor 40 will pass through the substrate 66 immediately proximate channel region 50. Bird's beak structure 76 and 78 will vary in the degree to which they impinge towards channel regions 50 from opposing sides of channel regions 50 as described previously. Due to the formation of notches 60 and 62, however, the current handling capability of transistor 40 will not be affected to any great degree by the variability of the formation of structures 76 and 78 because these structures reside outside of the channel region 50.

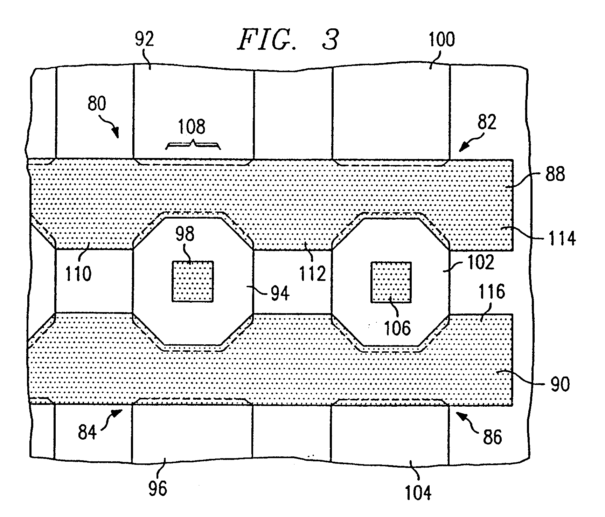

FIGURE 3 is a top view illustration of a layout of four transistors constructed according to the teachings of the present invention. FIGURE 3 illustrates transistors indicated generally at 80, 82, 84 and 86. Transistors 80 and 82 are controlled by a word line conductor 88. Similarly, transistors 84 and 86 are controlled by a word line conductor 90. Transistor 80 comprises a source region 92 and a drain region 94. Transistor 84 comprises a source region 96 and also utilizes drain region 94. A bit line contact 98 is formed to connect bit lines to drain region 94.

Similarly, transistor 82 comprises a source region 100 and a drain region 102. Transistor 86 comprises a source region 104 and also utilizes drain region 102. A bit line contact 106 is formed to connect drain region 106 to bit lines coupling a plurality of transistors. Regions 92, 94, 96, 100, 102, and 104 comprise diffused areas within a semiconductor substrate. Word line conductors 88 and 90 may comprise, for example, polysilicon doped with sufficient impurities so as to render it conductive. Bit line contacts 98 and 106 may comprise polycrystalline silicon doped with sufficient impurities so as to be rendered conductive or metal.

The teachings of the present invention will be described with reference to transistor 80 only for purposes of brevity. However, as shown in FIGURE 3, the teachings of the present invention are equally applicable to the structures illustrated for transistors 82, 84, and 86. Transistor 80 comprises a channel region 108 which is disposed in the semiconductor substrate immediately beneath word line conductor 88 and is separated from word line conductor 88 by a gate insulator layer which is not shown in FIGURE 3. The length of channel region 108 is determined as described previously by the distance between source region 92 and drain region 94. According to the teachings of the present invention, the effective width of channel region 108 is determined by the patterning of the material used to form word line conductor 88. Word line conductor 88 is formed to include trapezoidal extensions 110 and 112 on opposite sides of channel region 108. Any bird's beak structures present in transistor 80 will be disposed beneath the word line conductor 88 outside of channel region 108 due to the inclusion of trapezoidal extensions 110 and 112. Accordingly, the length and width of channel region 108 are determined by the edges of the patterned word line 88. Polycrystalline silicon and other conductive materials can be patterned to a much finer degree of tolerance than the tolerances associated with the formation of bird's beak structures. Accordingly, the transistors formed by the teachings of the present invention can be very small in size and still enjoy extremely good control over their current carrying capability and other design parameters.

An important technical advantage of the layout of the present invention is illustrated in FIGURE 3. The spacing of, for example, bit line contact 98 to word line conductor 88 is a critical design concern to prevent leakage between the bit line and the word line. Accordingly, most semiconductor processes require a certain minimum spacing between bit line conductors and word line conductors. The trapezoidal extensions 110 and 112 illustrated in FIGURE 3 can be added to the word line conductor 88 without increasing the overall size of the layout because they are placed in such a manner that word line conductor 88 does not come substantially any closer to bit line contact 98 because of the incorporation of extensions 110 and 112. As such, the trapezoidal extensions 110 and 112 greatly increase the predictability of the functionality of transistor 80 without increasing the overall layout size.

According to another embodiment of the present invention, the trapezoidal extensions can be used to prevent thinning of the word line conductors at the ends of a word line. For example, FIGURE 3 illustrates an extension 114 associated with transistor 100 and an extension 116 associated with transistor 86. As illustrated in FIGURE 3, transistors 82 and 86 comprise the ends of rows of a plurality of transistors. As such, word line conductor 88 and word line conductor 90 terminate after passing over the channel regions associated with transistors 82 and 86. During the processing of word line conductors 88 and 90, the ends of conventional word line conductors can thin as the word line conductors travel up the field oxide and are exposed to conventional semiconductor processes. The incorporation of extensions 114 and 116 shown in FIGURE 3 widen the ends of the word line conductors 88 and 90 to prevent this thinning at the ends of the word line conductors. As such, the transistors 82 and 86 enjoy the close process tolerances associated with the width and length control over the channel regions due to the incorporation of extensions 114 and 116 and also transistors 82 and 86 will not suffer the detrimental effects of the word line thinning common at the termination point of word line conductors.

Although the present invention has been described in detail, it should be understood that various changes, substitutions and alterations may be made to the embodiments disclosed herein without departing from the teachings of the present invention as defined solely by the spirit and scope of the appended claims.

## Claims

1. A transistor formed proximate a surface of a semiconductor layer, comprising:
a source region proximate the surface;
a drain region proximate the surface and spaced apart from said source region defining a channel region in the semiconductor layer between said source and drain regions; and
a gate conductor disposed proximate said channel region and insulated from said channel region, said gate conductor operable to electrically control the conductance of said channel region and comprising a notch proximate said channel region such that the length and width of the active portion of said channel region are substantially determined by the size of said gate conductor and said notch.

2. The transistor of claim 1 and further comprising:
a bit line coupling said drain region to other drain regions of other transistors of a transistor array; and
a bit line contact electrically connected to said bit line and said drain region.

3. The transistor of Claim 1 and further comprising:
a word line conductor disposed outwardly from the surface of the semiconductor layer, said gate conductor comprising a portion of said word line conductor proximate said channel region;
a first field insulator body disposed between the surface of the semiconductor layer and a portion of said word line conductor, said first field insulator body comprising a first bird's beak structure proximate said gate conductor and said channel region but spaced apart from said notch;
a second insulator body disposed between the surface of the semiconductor layer and a portion of said word line conductor, said second insulator body comprising a second bird's beak structure proximate said gate conductor and said channel region but spaced apart from said notch; and
a gate insulator layer disposed between said first and second bird's beak structures and between said channel region and said gate conductor.

4. An array of transistors formed proximate a surface of a semiconductor substrate, comprising:
a word line conductor disposed proximate the surface of the semiconductor substrate and insulated from the substrate;
a first source/drain region disposed proximate the surface of the substrate;
a second source/drain region disposed proximate the surface of the substrate and spaced apart from said first source/drain region to define a first channel region between said first and second source/ drain regions, a first portion of said word line conductor comprising a first gate conductor disposed proximate said first channel region and insulated from said channel region and operable to electrically control said first channel region;
a third source/drain region disposed proximate the surface of the substrate;
a fourth source/drain region disposed proximate the surface of the substrate and spaced apart from said third source/drain region to define a second channel region between said third and fourth source/drain regions, a second portion of said word line conductor comprising a second gate conductor disposed proximate said second channel region and insulated from said channel region and operable to electrically control said second channel region;
an extension body of said word line conductor integral with said word line conductor and extending from said word line conductor a predetermined distance between said second and fourth source/drain regions such that the length and width of the active portion of said first and second channel regions are substantially determined by the size of said gate conductor and said extension body; and
said first and second source/drain regions, said first channel region, and said first gate conductor associated with a first transistor of the transistor array, said third and fourth source/drain regions, said second channel region, and said second gate conductor associated with a second transistor of the transistor array.

5. A transistor formed proximate a surface of a semiconductor substrate, comprising:
a source region proximate the surface;
a drain region proximate the surface and spaced apart from said source region defining a channel region of the substrate between said source and drain regions; and
a gate conductor disposed proximate said channel region and insulated from said channel region, said gate conductor operable to electrically control the conductance of said channel region and comprising a notch proximate said channel region such that the length and width of the active portion of said channel region are substantially determined by the size of said gate conductor and said notch;
a bit line coupling said drain region to other drain regions of other transistors of a transistor array; and
a bit line contact electrically connected to said bit line and said drain region;
a word line conductor disposed outwardly from the surface of the substrate, said gate conductor comprising a portion of said word line conductor proximate said channel region;
a first field insulator body disposed between the surface of the substrate and a portion of said word line conductor, said first field insulator body comprising a first bird's beak structure proximate said gate conductor and said channel region but spaced apart from said notch;
a second insulator body disposed between the surface of the substrate and a portion of said word line conductor, said second insulator body comprising a second bird's beak structure proximate said gate conductor and said channel region but spaced apart from said notch; and
a gate insulator layer disposed between said first and second bird's beak structures and between said channel region and said gate conductor.

6. A method for forming a transistor proximate a surface of a semiconductor substrate, comprising the steps of:
forming a source region proximate the surface;
forming a drain region proximate the surface and spaced apart from the source region defining a channel region of the substrate between the source and drain regions; and
forming a gate conductor disposed proximate the channel region and insulated from the channel region, the gate conductor operable to electrically control the conductance of the channel region and comprising a notch proximate the channel region such that the length and width of the active portion of the channel region are substantially determined by the size of the gate conductor and the notch.

7. The method of claim 6 and further comprising the steps of:
forming a bit line coupling the drain region to other drain regions of other transistors of a transistor array; and
forming a bit line contact electrically connected to the bit line and the drain region.

8. The method of Claim 6 and further comprising the steps of:
forming a word line conductor disposed outwardly from the surface of the substrate, the gate conductor comprising a portion of the word line conductor proximate the channel region;
forming a first field insulator body disposed between the surface of the substrate and a portion of the word line conductor, the first field insulator body comprising a first bird's beak structure proximate the gate conductor and the channel region but spaced apart from the notch;
forming a second insulator body disposed between the surface of the substrate and a portion of the word line conductor, the second insulator body comprising a second bird's beak structure proximate the gate conductor and the channel region but spaced apart from the notch; and
forming a gate insulator layer disposed between the first and second bird's beak structures and between the channel region and the gate conductor.

9. An array of transistors, wherein the transistors include transistors as claimed in any of claims 1, 2, 3, and 5.
